# EUROPEAN PATENT SPECIFICATION

(11) **EP 0 516 379 B1**
(45) Date of publication and mention of the grant of the patent: **28.06.1995**
(21) Application number: 92304771.6
(22) Date of filing: 27.05.1992
(51) Int. Cl.: H03K 3/03, H03L 7/099

(54) **Digital voltage-controlled oscillators**
Digitale spannungsgesteuerte Oszillatoren
Oscillateurs numériques contrôlés en tension

(30) Priority: 28.05.1991 JP 153897/91
(43) Date of publication of application: 02.12.1992
(73) Proprietor: SONY CORPORATION, Tokyo 141 (JP)
(72) Inventor: Yamada, Takaaki, c/o Pat. Div., Sony Corporation, Tokyo 141 (JP); Yamagata, Hiroshi, c/o Pat. Div., Sony Corporation, Tokyo 141 (JP)
(74) Representative: Cotter, Ivan John

(56) References cited:
- EP-A- 0 403 990
- US-A- 5 068 628
- IEEE JOURNAL OF SOLID-STATE CIRCUITS vol. 25, no. 6, December 1990, NEW YORK pages 1414 - 1425 R. BATRUNI ET AL. 'Mixed Digital/Analog Signal Processing for a Single-Chip 2B1Q U-Interface Transceiver'
- IBM TECHNICAL DISCLOSURE BULLETIN. vol. 31, no. 4, September 1988, NEW YORK US pages 313 - 315 , XP51450 'DIGITAL DELAY CONTROLLED OSCILLATOR'

## Description

This invention relates to digital voltage-controlled oscillators (VCOs).

Generally, in a digital VCO, the frequency of the original signal is divided down and the signal so obtained is decoded so that a signal with a required phase is obtained. When generating a signal having a required phase in this way, the phase which can be obtained is given, with the frequency of the original signal represented by f₀ and the frequency division factor represented by N, by nπ/N (n = 0, 1, ... 2N - 1), that is 2N phases can be obtained. In the conventional VCO, there is the disadvantage that the greater the frequency division factor N is, the lower the frequency becomes, or the higher the original signal frequency should be. Thus, the clock frequency should be increased in order to decrease the phase pitch of the output signal. For this reason, a VCO of the type described has not been applicable, for example, to the colour subcarrier signal (3.58 MHz) of an NTSC video signal in a television receiver. More specifically, when the phase pitch accuracy is to be raised to 1 degree (0.78 nS), a frequency of 1/0.78 nS = 1.3 GHz is required. Since a clock signal with such an extremely high frequency is necessary, the application has been difficult to realise.

When an oscillator circuit using a quartz oscillator crystal is used for the VCO in a phase locked loop (PLL), since the variable range is as narrow as the accuracy of the centre frequency, adjustment of the centre frequency becomes necessary. On the other hand, when an LC oscillation circuit is used for the VCO, there is a possibility of the PLL producing pseudo lock-in. If the variable range is narrowed in order to avoid that possibility, then adjustment of the centre frequency becomes necessary for the reason described above.

A VCO having the features set out in the pre-characterising portion of Claim 1 is disclosed in IEEE Journal of Solid-State Circuits, Vol. 25, No. 6, December 1990, pages 1414 - 1425, R. Batruni et al "Mixed Digital/Analog Signal Processing for a Single Chip 2B1Q U-Interface Transceiver". With this circuit, the phase of an output signal having the same frequency as the oscillation frequency of the ring oscillator can be shifted with respect to the oscillation frequency. A similar circuit is disclosed in EP-A-0403990.

According to the present invention there is provided a digital VCO comprising:
a ring oscillator formed of a plurality of inverters connected in series, the delay amount of each inverter being controllable;
a frequency control circuit for controlling the delay amount of the inverters to control the oscillation frequency of said ring oscillator to correspond to a reference frequency;
a selector switch for selecting specified output taps from output taps of the ring oscillator, one output tap being provided for each of said inverters, to take the output therefrom; and
switching control means for controlling said selector switch;
characterised in that the switching control means is arranged to control the selector switch such that the output taps from which the output is taken are switched cyclically.

Embodiments of the present invention provide a digital VCO capable of changing its output with a phase pitch smaller than the phase pitch corresponding to the clock frequency.

By forming a PLL circuit with a ring oscillator used as the VCO and cyclically switching the output taps selected from output taps of the ring oscillator for taking the outputs therefrom, thereby rotating the phase, it becomes possible for frequency of the output signal to change finely. Thus, an output with a much smaller phase pitch than the oscillation cycle of the ring oscillator can be obtained.

Digital VCOs embodying the invention are useful in a variety of applications, in particular in a digital PLL in which the ability to change the output with a fine phase pitch is required.

Preferred embodiments of the invention will now be described, by way of example, with reference to the accompanying drawings in which:
Figure 1 is a block diagram of a first embodiment of a digital VCO according to the present invention;
Figure 2 is a block diagram of part of the digital VCO shown in Figure 1;
Figure 3 is a waveform chart showing the operation of the digital VCO shown in Figure 1;
Figure 4 is a block diagram of a switch portion of the digital VCO shown in Figure 1;
Figure 5 is an operating waveform chart explaining a condition in which the phase is delayed in the digital VCO shown in Figure 1;
Figure 6 is a block diagram of part of the digital VCO of Figure 1 in which latch circuits are provided;
Figure 7 is an operating waveform chart for the case where latch circuits are provided as shown in Figure 6;
Figure 8 is a block diagram of part of a digital VCO embodying the invention showing the case where 2-step switching is performed;
Figure 9 is an operating waveform chart for the case where 2-step switching is performed in the embodiment shown in Figure 8; and
Figure 10 is a block diagram of a further embodiment of a digital VCO according to the invention.

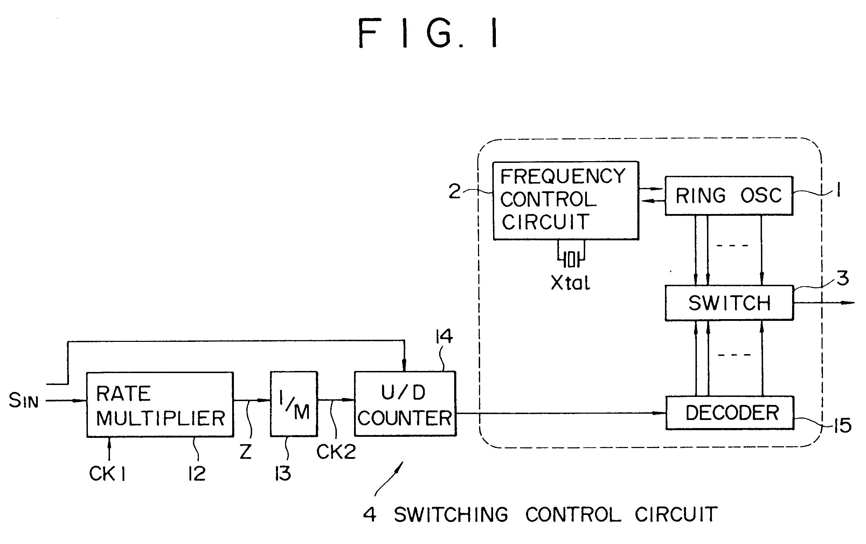

Figure 1 shows a block diagram of a first embodiment of a digital VCO according to the present invention. The digital VCO comprises a ring oscillator 1, a ring oscillation controlling PLL 2, a selector switch 3, and a switching control circuit 4.

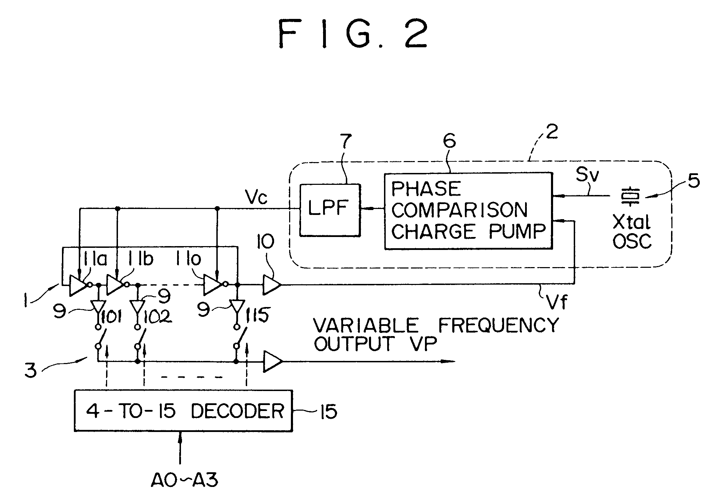

The ring oscillator 1 is provided with 15 output taps 101 to 115 as shown in the block diagram of the main portion of the digital VCO shown in Figure 2. Of the taps 101 to 115, the taps from which the output signal is taken are cyclically switched by the selector switch 3 so that the frequency of the output signal Vp is changed.

The ring oscillation controlling PLL 2 comprises a reference frequency oscillator 5, a phase comparison charge pump 6, and a low-pass filter 7. The reference frequency oscillator 5 is formed of a VCO using a quartz oscillator and accurately generates the reference frequency for the ring oscillator 1.

The oscillating output signal Sv of the reference frequency oscillator 5 is supplied to the phase comparison charge pump 6. The phase comparison charge pump 6 receives a fixed output signal Vf of the ring oscillator 1 through a buffer amplifier 10. In this phase comparison charge pump 6, the oscillating output signal Sv and the fixed phase output signal Vf are compared for phase.

The phase difference between the signals detected by the phase comparison charge pump 6 is supplied to the low-pass filter 7 and a control voltage Vc is generated therein. The control voltage Vc is supplied to each of the inverter circuits 11a to 11o forming the ring oscillator 1.

The inverter circuits 11a to 11o are each arranged to serve as an inverter for controlling the delay amount depending on the value of the control voltage Vc supplied thereto. Accordingly, even if there is a phase difference present, this can be cancelled by means of the control voltage Vc, and the reference oscillation frequency of the ring oscillator 1 is thereby controlled to coincide accurately with the oscillation frequency of the reference frequency oscillator 5 using the quartz oscillator. A buffer circuit 9 is provided between each of the output terminals of the inverter circuits 11a to 11o and the output taps 101 to 115, whereby the output of the ring oscillator is taken from each of the output taps 101 to 115 through the associated buffer circuit 9.

The switching control circuit 4 is provided for cyclically switching the taps selected from the output taps 101 to 115 of the ring oscillator 1 from which the output is taken so that the frequency of the output signal may be changed. In this embodiment, it is formed of a rate multiplier 12, a frequency divider 13, an up/down (U/D) counter 14, and a decoder 15.

The rate multiplier 12 is a counter in which the ratio of the number of pulses of an output pulse Z to the number of pulses of the input clock pulse CK1 is determined in proportion to a preprogrammed rate input S_{IN}. The rate input S_{IN} is given for example in 7 bits. Hence, up to 128 different outputs Z can be set up.

The intervals of pulses of the output pulse train of the above described output Z are not always equal by reason of the internal circuit configuration of the rate multiplier 12. In order to equalise the pulse intervals of the output pulse train, the frequency of the clock pulse CK1 is previously multiplied by M and the output Z is arranged to be divided down to 1/M by the frequency divider 13. The clock pulse CK2, having undergone frequency division by M in the frequency divider 13, is supplied to the decoder 15 through the U/D counter 14, which is a modulo-15 counter.

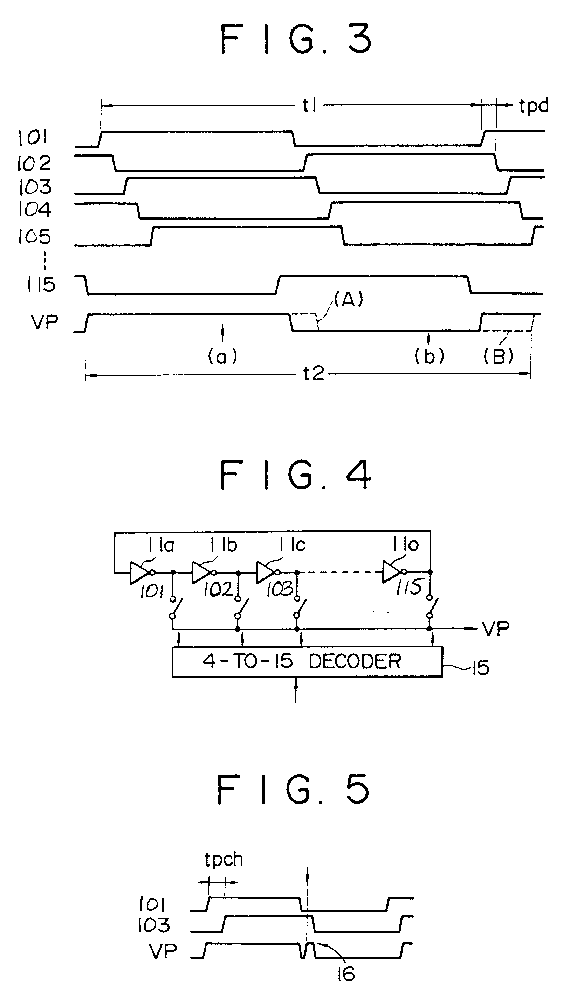

The digital VCO described above operates in the following way. Suppose that the switch for the tap 101 of the 15 output taps 101 to 115 is now ON. At this time, a signal of the same waveform as the waveform on the output terminal 101 appears as the output signal VP as shown in the operating waveform chart of Figure 3.

Then, if the output tap 101 is switched to the output tap 103 at the time (a) indicated in Figure 3, the waveform of the output signal Vp will change to that indicated by the dotted line (A) in Figure 3.

Further, if the output tap is switched from 103 to 105 at the time (b), the waveform will then change to that indicated by the dotted line (B) in Figure 3.

By rotating the taps from which the output is taken as described above, the frequency of the output signal Vp is changed from the frequency 1/t1 before the switch selection was performed to 1/t2, which is a lower frequency than before. The amount of the change in frequency is determined by how frequently the switching is effected. When the direction of switching of the tape is reversed, the frequency can be increased.

The above-described change in frequency will be described below using numerical expressions. First, the frequency f_{Z} of the output Z of the rate multiplier 12 is given by${\text{f}}_{\text{Z}} {\text{= N/128·f}}_{\text{CK1}}$
where N represents a 7-bit input value and f_{CK1} represents the clock frequency.

Accordingly, the clock frequency f_{CK2} input to the U/D counter 14 will be expressed as${\text{f}}_{\text{CK2}} {\text{= N/128M·f}}_{\text{CK1}}$
where M represents the frequency division factor. If the difference in the frequency of the output signal Vp is represented by Δfᵥₚ, the same will be expressed as${\text{Δf}}_{\text{vp}} {\text{= N/128M·f}}_{\text{CK1}} {\text{·f}}_{\text{ROSC}} {\text{·t}}_{\text{pCH}}$
where f_{ROSC} represents the oscillation frequency of the ring oscillator 1 and t_{pCH} represents the phase pitch of the VCO, which is a pitch twice as large as the phase difference t_{pd} in Figure 3. Incidentally, because the ring oscillator 1 is a 15-stage ring oscillator, the phase pitch is given by${\text{t}}_{\text{pCH}} {\text{= 1/(15·f}}_{\text{ROSC}} \text{)}$

Since f_{CK1}, f_{ROSC}, t_{pCH}, and M are all constants, the digital VCO of the first embodiment shown in Figure 1 provides a frequency change in proportion to the input 7-bit value N.

In the configuration of Figure 1, though the frequency divider 13 is disposed in the stage subsequent to the rate multiplier 12, this order may be reversed to provide the output f_{CK2} of the same frequency. However, since intervals of the output pulses of the rate multiplier 12 are not equal as described above, it is better to arrange the frequency divider 13 to follow the rate multiplier 12 because the degree of the inequality of intervals is thereby remedied.

The digital VCO of this embodiment is arranged to provide a fine phase pitch through the operation described above. However, when the digital VCO is actually operated, the timing of switching can be a troublesome problem.

For example, when switching is made in the direction to delay the phase as shown in the block diagram of Figure 4 and the operating waveform chart of Figure 5, a spike 16 sometimes appears in the output signal Vp when the output is switched from the tap 101 to the tap 103. Existence of such a spike 16 involves a risk of erroneous inversion of the flip-flop constituting a frequency dividing circuit provided in the following stage. This is therefore a serious problem.

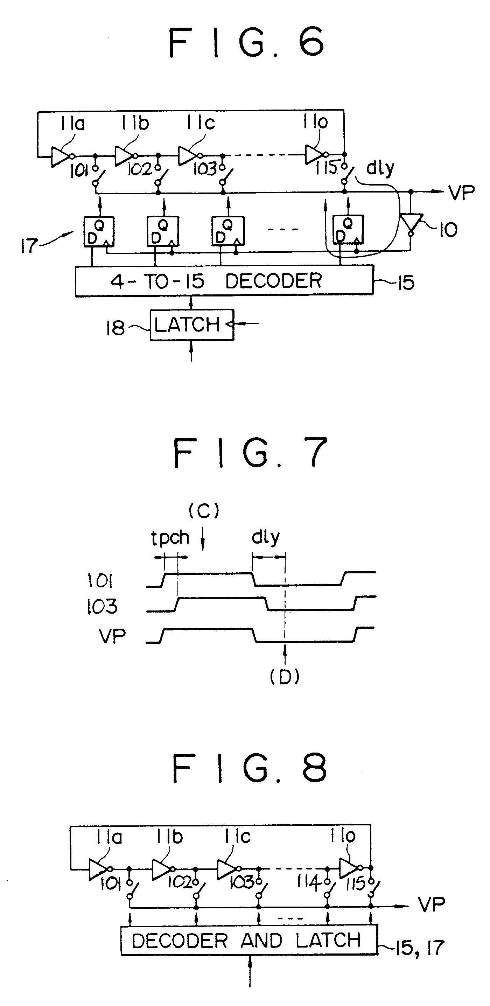

In order to prevent such a spike 16 from being produced, favourable results are obtained by providing a first latch circuit 17 and a second latch circuit 18 as shown in the block diagram of Figure 6.

By the provision of the first latch circuit 17, even if an input for switching the output from the tap 101 to the tap 103 is given at the time indicated by the arrow (C) in the operating waveform chart of Figure 7, switching is actually effected at the time (D), a predetermined time delay (dly) after the inversion of the signal of the output tap 101. Therefore, in the configuration of Figure 6, production of the spike 16 as shown in Figure 5 can be prevented. The second latch circuit 18 is provided for preventing the first latch circuit 17 from operating at a turn of the output of the decoder 15, whereby time for the first latch circuit 17 to stabilise its latch operation is provided.

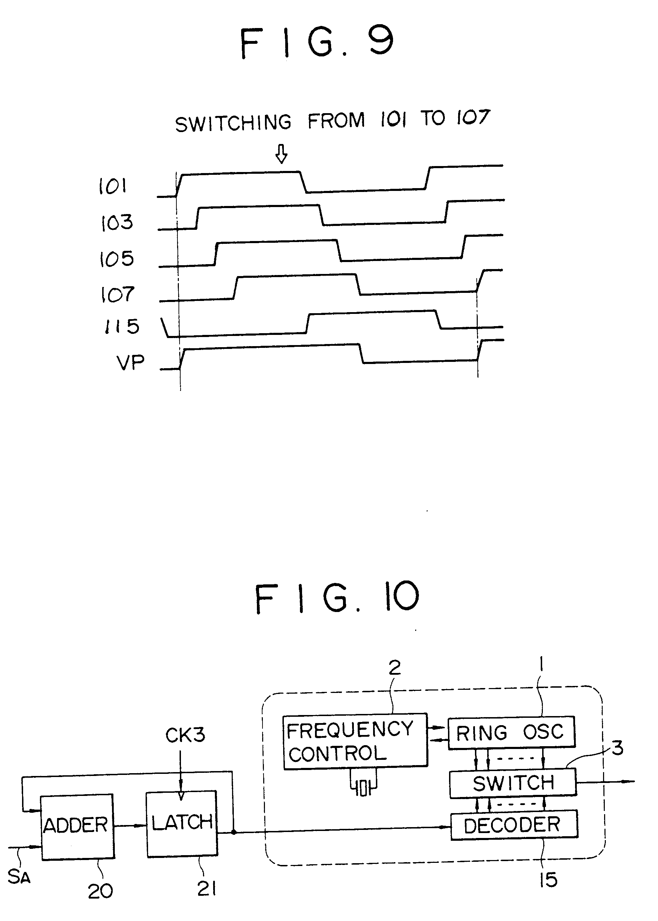

A second embodiment of the invention will now be described with reference to Figures 8 to 10. Although a method in which the phase pitch is changed one step at a time, ie the phase pitch is changed by an amount corresponding to two inverters at a time, was described above, the phase pitch can be changed two steps or more at a time as shown in the block diagram of the main portion of a digital VCO of Figure 8 and the operating waveform chart of Figure 9. Figure 9 shows the case where switching is made three steps at a time from the output tap 101 to the output tap 107.

In the case where the switching is performed as described above in plural steps, ie two steps or more, at a time it is preferable to use an adder 20 and a latch circuit 21 as the switching control circuit 4 as shown in the block diagram of Figure 10. The adder 20 is provided with two inputs, of which one is supplied with a fixed value and the other is supplied with a value S_{A} as an addend. The addend S_{A} is a value obtained by A/D conversion of an error voltage of the PLL, such as ... -1, 0, +1, +2, .... In the case of the embodiment shown in Figure 10, the frequency of the output signal Vp is varied by both the value of the addend S_{A} and the frequency of a clock CK3 supplied to the latch circuit 21.

In a conventional digital VCO using a programmable divide-by-n counter, the phase pitch can only be reduced to an amount comparable with the period of the clock pulse. Since the digital VCO embodying the invention uses a ring oscillator 1 as described above and is arranged such that the output taps are cyclically switched, the output can be varied in a smaller phase pitch than that of the conventional digital VCO (for example, in 1/15 of the pitch).

Further, by causing the oscillation frequency of the ring oscillator 1 to lock onto the reference frequency of a quartz oscillator or the like, the centre frequency can be accurately held. Furthermore, since a much wider variable range can be obtained as compared with the generally used VCXO, a non-adjustment system can be easily achieved. Therefore, when PLL circuits are constructed with all such circuits as phase comparators and LPFs (lag/lead filters) controlled digitally to meet the expected increase in demands for digital signal processing circuits, embodiments of the present invention are suitable for use as digitally controllable VCOs.

In the embodiments of the present invention described above, the PLL circuit is constructed with the ring oscillator used as the VCO and the taps selected from the output taps of the ring oscillator to take the output therefrom are cyclically switched, thereby to rotate the phase. Therefore, the frequency of the signal taken out of the ring oscillator can be varied finely. Accordingly, it is possible to obtain an output with a much smaller phase pitch than the oscillation frequency of the ring oscillator and to provide a digital VCO having a fine phase pitch without using a higher frequency clock signal. Thus, it is possible to realise a PLL which is kept in phase accurately and to obtain an output with accurate phase while using the same design rules and kinds of transistors.

## Claims

1. A digital VCO comprising:
a ring oscillator (1) formed of a plurality of inverters (11a ... 11o) connected in series, the delay amount of each inverter (11a ... 11o) being controllable;
a frequency control circuit (2) for controlling the delay amount of the inverters (11a ... 11o) to control the oscillation frequency of said ring oscillator (1) to correspond to a reference frequency;
a selector switch (3) for selecting specified output taps from output taps (101 ... 115) of the ring oscillator (1), one output tap (101 ... 115) being provided for each of said inverters (11a ... 11o), to take the output therefrom; and
switching control means (4) for controlling said selector switch (3);
characterised in that the switching control means (4) is arranged to control the selector switch (3) such that the output taps from which the output is taken are switched cyclically.

2. A digital VCO according to claim 1, wherein said switching control means (4) comprises a rate multiplier (12), a frequency divider (13), an up/down counter (14), and a decoder (15).

3. A digital VCO according to claim 1, wherein said switching control means comprises an adder (20), a first latch circuit (21), and a decoder (15).

4. A digital VCO according to claim 2 or claim 3, comprising a second latch circuit (17) operative to latch an output of the decoder (15) in synchronism with the output of said ring oscillator (1) so that an unwanted pulse is prevented from being produced in the output signal.

## Patentansprüche

1. Digitaler VCO, mit:
einem Ringoszillator (1), der aus mehreren Invertern (11a... 11o) besteht, die seriell miteinander verbunden sind, wobei der Verzögerungsgrad eines jeden Inverters (11a... 11o) steuerbar ist;
einer Frequenzsteuerschaltung (2) zur Steuerung des Verzögerungsgrads der Inverter (11a... 11o), um die Schwingungsfrequenz des Ringoszillators (1) so zu steuern, daß sie einer Referenzfrequenz entspricht;
einem Auswahlschalter (3) zur Auswahl bestimmter Ausgangsanzapfungen von Ausgangsanzapfungen (101... 105) des Ringoszillators (1), wobei eine Ausgangsanzapfung für jeden Inverter (11a... 11o) vorgesehen ist, um das Ausgangssignal davon abzunehmen; und
einer Schaltsteuereinrichtung (4) zur Steuerung des Auswahlschalters (3);
dadurch gekennzeichnet, daß die Schaltsteuereinrichtung (4) eingerichtet ist, den Auswahlschalter (3) so zu steuern, daß die Ausgangsanzapfungen, von denen das Ausgangssignal abgenommen wird, zyklisch geschaltet werden.

2. Digitaler VCO nach Anspruch 1, wobei die Schaltsteuereinrichtung (4) einen Verhältnismultiplizierer (12), einen Frequenzteiler (13), einen Auf-Abwärtszähler (14) und einen Decodierer (15) aufweist.

3. Digitaler VCO nach Anspruch 1, wobei die Schaltsteuereinrichtung einen Addierer (20), eine erste Latch-Schaltung (21) und einen Decodierer (15) aufweist.

4. Digitaler VCO nach Anspruch 2 oder 3, mit einer zweiten Latch-Schaltung (17), die ein Ausgangssignal des Decodierers (15) synchron mit dem Ausgangssignal des Ringoszillators (1) verriegeln kann, so daß verhindert wird, daß ein unerwünschter Impuls im Ausgangssignal erzeugt wird.

## Revendications

1. Oscillateur numérique commandé en tension, ou "VCO numérique", comprenant:
- un oscillateur en anneau (1) formé d'une pluralité d'inverseurs (11a à 11o) montés en série, la valeur du retard de chaque inverseur étant commandable;
- un circuit de commande de fréquence (2) pour commander la valeur du retard des inverseurs (11a à 11o) pour commander la fréquence d'oscillation dudit oscillateur en anneau (1) pour qu'elle corresponde à une fréquence de référence;
- un commutateur sélecteur (3) pour sélectionner des prises de sortie spécifiées parmi des prises de sortie (101 à 115) de l'oscillateur en anneau (1), une prise de sortie (101 à 115) étant prévue pour chacun desdits inverseurs (11a à 11o) pour prélever le signal de sortie à partir de celle-ci; et
- des moyens de commande de commutation (4) pour commander ledit commutateur sélecteur (3), caractérisé en ce que les moyens de commande de commutation (4) sont agencés pour commander le commutateur sélecteur (3) de telle manière que les prises de sortie à partir desquelles le signal de sortie est prélevé soient commutées cycliquement.

2. Oscillateur numérique commandé en tension selon la revendication 1, dans lequel lesdits moyens de commande de commutation (4) comprennent un multiplieur de cadence (12) un diviseur de fréquence (13), un compteur-décompteur (14) et un décodeur (15).

3. Oscillateur numérique commandé en tension selon la revendication 1, dans lequel lesdits moyens de commande de commutation comprennent un additionneur (20), un premier circuit à verrouillage (21) et un décodeur (15).

4. Oscillateur numérique commandé en tension selon la revendication 2 ou la revendication 3, comprenant un deuxième circuit à verrouillage (17) fonctionnant pour verrouiller un signal de sortie du décodeur (15) en synchronisme avec le signal de sortie dudit oscillateur en anneau (1) de manière qu'une impulsion non désirée soit empêchée d'être produite dans le signal de sortie.
